# EUROPÄISCHE PATENTANMELDUNG

(11) **EP 4 187 779 A1**
(43) Veröffentlichungstag der Anmeldung: **31.05.2023**
(21) Anmeldenummer: 21210237.0
(22) Anmeldetag: 24.11.2021
(51) Int. Cl.: H02S 50/10, H02S 50/15

(54) **KONTAKTVORRICHTUNG SOWIE ANORDNUNG UND VERFAHREN ZUR CHARAKTERISIERUNG VON TEILZELLEN**

(71) Anmelder: Meyer Burger (Germany) GmbH, 09337 Hohenstein-Ernstthal (DE)
(72) Erfinder: Waltiger, Andreas, 09337 Hohenstein-Ernstthal (DE); Schitthelm, Frank, 09337 Hohenstein-Ernstthal (DE)
(74) Vertreter: Kailuweit & Uhlemann Patentanwälte Partnerschaft mbB

(57) **Zusammenfassung**

Die Erfindung betrifft eine Kontaktvorrichtung zur Kontaktierung mehrerer physisch und elektrisch voneinander getrennter Teilzellen von Solarzellen sowie eine Anordnung und ein Verfahren zur Charakterisierung solcher Teilzellen. Die Kontaktvorrichtung umfasst ein flächiges Trägerelement mit mindestens zwei Rückseitenkontaktanordnungen oder mindestens zwei flächige Trägerelemente mit jeweils mindestens einer Rückseitenkontaktanordnung, mindestens eine Frontseitenkontaktanordnung und mindestens eine Haltevorrichtung zur Fixierung der Teilzellen auf dem oder den flächigen Trägerelementen. Jede Rückseitenkontaktanordnung und jede Frontseitenkontaktanordnung korrespondiert mit einem Rückseiten- bzw. Frontseitenkontakt einer der Teilzellen. Entweder sind die Rückseitenkontaktanordnungen der einzelnen Teilzellen getrennt elektrisch kontaktierbar, während die Frontseitenkontaktanordnungen aller Teilzellen elektrisch zu einer gemeinsamen Frontkontaktanordnung verbunden und mit einem gemeinsamen Frontseitenpotential kontaktierbar sind, oder die Frontseitenkontaktanordnungen der einzelnen Teilzellen sind getrennt elektrisch kontaktierbar, während die Rückseitenkontaktanordnungen aller Teilzellen elektrisch zu einer gemeinsamen Rückkontaktanordnung verbunden und mit einem gemeinsamen Rückseitenpotential kontaktierbar sind. Mit Hilfe der Kontaktvorrichtung können mehrere Teilzellen zeitgleich während eines Beleuchtungsvorganges oder nacheinander während aufeinanderfolgender Beleuchtungsvorgänge elektrisch charakterisiert werden.

## Beschreibung

Gegenstand der vorliegenden Erfindung ist eine Kontaktvorrichtung zur Kontaktierung mehrerer physisch und elektrisch voneinander getrennter Teilzellen von Solarzellen. Weiterhin werden eine Anordnung zur Charakterisierung von aus einer oder mehreren Vollzellen durch Teilung hervorgegangener Teilzellen sowie ein Verfahren zur Charakterisierung von aus Vollzellen durch Teilung hervorgegangener Teilzellen offenbart.

Die Erfindung betrifft jeden Typ von Solarzellen bei denen durch Lichteinwirkung eine Trennung von elektrischen Ladungsträgern erfolgt. Dazu gehören Solarzellen mit einem pn-Übergang oder auch solche bei denen die erforderliche Bandverbiegung durch unterschiedliche Materialien hervorgerufen wird (Heteroübergang).

Zur Abnahme der bei Bestrahlung mit Sonnenlicht entstehenden Ladungsträger werden die Vorder- und die Rückseite der Solarzellen kontaktiert. Durch die serielle Verschaltung der Solarzellen im Modul treten hierbei Ohmsche Leitungsverluste (*Pᵥₑᵣₗᵤₛₜ* = *I*² · *Rₛₑᵣ*) auf. Um diese Verluste zu reduzieren wurde dazu übergegangen, vollständige Solarzellen, hier auch Vollzellen genannt, in kleinere Teilzellen (Sub-Zellen) aufzuteilen, um entsprechend auch den leitungsgeführten Strom I zu teilen bzw. zu reduzieren. Die lateralen Abmessungen dieser Teilzellen sind geringer. Damit reduziert sich der generierte Strom I und damit auch die Verluste in den Leitungen. Ausgehend von einer Aufteilung von vollständigen Solarzellen in jeweils zwei Sub-Zellen (Halbzellen, Half-Cell) bzw. Teilzellen, sind nunmehr auch weitere Unterteilungen (3, 4, 5, 6 ...n Sub-Zellen) Stand der Technik.

Dabei werden in der Fertigung aus verschiedenen Gründen zunächst Vollzellen mit großen lateralen Abmessungen erzeugt. Es hat sich gezeigt, dass bei einer Trennung der Vollzellen in Teilzellen nach der Qualifizierung (elektrischen Messung) die Messdaten im Rahmen der geforderten Messgenauigkeit nicht zur Hälfte der jeweiligen Teilzelle zugordnet werden können. Aber auch Verluste durch die Teilung und weiterer nachfolgender Prozessschritte, z.B. Kantenpassivierung und Lightsoaking, können damit nicht erfasst werden. Daher ist eine elektrische Charakterisierung der Teilzellen nach ihrer Erzeugung notwendig.

Es existiert eine Reihe von Vorrichtungen, die dazu dienen sollen, Halbzellen und weitere Unterteilungen einer Vollzelle hinsichtlich ihrer Betriebsparameter zu testen.

Gegenstand der CN 207 117 571 U ist eine Vorrichtung, die es gestatten soll, Halbzellen in für Vollzellen vorgesehenen Testern zu testen. Die Vorrichtung kontaktiert eine Halbzelle mittels einer Mehrzahl von Pins. Für die Testung unterschiedlicher Zellgrößen ist vorgesehen, dass ein Teil der Pins abgesenkt werden kann. Eine zentrale Pin-Gruppe bleibt hervorstehend, während weitere Pin-Gruppen, die die zentrale Pin-Gruppe umgeben, in ihrer Höhe reduziert werden können. Auf diese Weise können stets die notwendigen Pins für die aktuelle Testaufgabe (Vollzelle, Half-Cell, Sub-Cells) in eine Arbeitsposition gebracht und genutzt werden. Nicht vorgesehen ist, an mehreren Teilzellen gleichzeitig zu messen.

Die CN 210 123 451 U und CN 212 379 533 U beschreiben Träger zur Testung von HalbZellen (optional von Sub-Zellen) mittels Oberflächenkontaktierung. Dabei weisen die Träger Bügel auf, an denen Kontaktspitzen angeordnet sind. Zur Anpassung an unterschiedliche Zellgrößen ist eine Verschiebbarkeit der Bügel vorgesehen. Nicht genannt ist die parallele Testung mehrere Teilzellen.

Die WO2017116716A1 beschreibt eine Solarzellenanordnung, bei der eine Vollzelle mit einer Rückseitenmetallisierung versehen wird. Anschließend wird die Vollzelle in eine Vielzahl von Subzellen unterteilt, wobei ein gemeinsamer Träger als Rückseitenelektrode erhalten bleibt. Dies ermöglicht es vorteilhaft, die Rückseitenelektrode an nur einer Stelle zu kontaktieren. Nachteilig ist jedoch, dass nach den Messungen ein erneuter Trennschritt notwendig ist, der die Teilzellen endgültig trennt. Dieser kann zu weiteren Fehlern führen, die dann nicht erkannt werden.

Die vorhandene Anlagentechnik ist auf die Testung von Vollzellen ausgelegt und damit nur bedingt für die Verwendung mit Teilzellen geeignet. Insbesondere können nicht mehrere Teilzellen gleichzeitig charakterisiert werden.

Es stellt sich somit die Aufgabe, eine Vorrichtung vorzuschlagen, mit der sich aus Vollzellen hervorgegangene Teilzellen in bekannten Anlagen für Vollzellen qualifizieren lassen. Weiterhin sollen eine Anordnung sowie ein Verfahren zur Qualifizierung von Teilzellen mittels der erfindungsgemäßen Kontaktvorrichtung bereitgestellt werden.

Die Qualifizierung (Testung) erfolgt indem die Solarzelle bzw. die Teilzellen einem Lichtblitz, üblicherweise über einen Zeitraum von 4 ms bis 600 ms, ausgesetzt werden. In dieser Zeit erfolgt eine Strom-Spannung-Kennlinienmessung (I-U-Messung) zur Kennlinienerfassung. Die Qualifizierung gestattet die Einordnung der Teilzellen in entsprechende Qualitätsstufen. Zur Qualifizierung werden die Solarzellen bzw. Teilzellen auf einem flächigen Trageelement angeordnet und auf der vom Trageelement abgewandten Seite mit dem Lichtblitz bestrahlt. Die mit dem Lichtblitz bestrahlte Seite ist die Beleuchtungsseite. Sie ist mit der Seite identisch, auf der die Solarzellen im späteren Einsatz das Sonnenlicht empfangen.

Erfindungsgemäß wird die Aufgabe mit einer Kontaktvorrichtung nach Anspruch 1 gelöst. Eine Anordnung zur Charakterisierung von aus einer Vollzelle durch Teilung hervorgegangener Teilzellen wird in nebengeordneten Anspruch offenbart. Ein Verfahren zur Charakterisierung von aus Vollzellen durch Teilung hervorgegangener Teilzellen ist Gegenstand eines weiteren nebengeordneten Anspruchs. Vorteilhafte Ausführungen bzw. Verfahrensweisen sind in den rückbezogenen Unteransprüchen offenbart.

Die erfindungsgemäße Kontaktvorrichtung zur Kontaktierung mehrerer physisch und elektrisch voneinander getrennter Teilzellen, wobei jede der Teilzellen mindestens einen Rückseitenkontakt und mindestens einen Frontseitenkontakt aufweist, umfasst:
- ein flächiges Trägerelement mit mindestens zwei Rückseitenkontaktanordnungen oder mindestens zwei flächige Trägerelemente mit jeweils mindestens einer Rückseitenkontaktanordnung, wobei jede Rückseitenkontaktanordnung zu dem mindestens einen Rückseitenkontakt einer der Teilzellen korrespondiert und geeignet ist, den mindestens einen Rückseitenkontakt der Teilzelle elektrisch zu kontaktieren,
- mindestens eine Frontseitenkontaktanordnung, wobei jede Frontseitenkontaktanordnung zu dem mindestens einen Frontseitenkontakt einer der Teilzellen korrespondiert und geeignet ist, den mindestens einen Frontseitenkontakt der Teilzelle elektrisch zu kontaktieren, und
- mindestens eine Haltevorrichtung zur Fixierung der Teilzellen auf dem oder den flächigen Trägerelementen,
wobei
a) die Rückseitenkontaktanordnungen der einzelnen Teilzellen getrennt elektrisch kontaktierbar sind, während die Frontseitenkontaktanordnungen aller Teilzellen elektrisch zu einer gemeinsamen Frontkontaktanordnung verbunden und mit einem gemeinsamen Frontseitenpotential kontaktierbar sind,
   oder
b) die Frontseitenkontaktanordnungen der einzelnen Teilzellen getrennt elektrisch kontaktierbar sind, während die Rückseitenkontaktanordnungen aller Teilzellen elektrisch zu einer gemeinsamen Rückkontaktanordnung verbunden und mit einem gemeinsamen Rückseitenpotential kontaktierbar sind.

Im vorliegenden Zusammenhang bedeutet "Frontseitenkontakt", dass ein elektrisch leitfähiger Kontakt zu dem ersten Gebiet der Absorberschicht besteht, und "Rückseitenkontakt", dass ein elektrisch leitfähiger Kontakt zu dem zweiten Gebiet der Absorberschicht besteht. Somit können Frontseitenkontakt und Rückseitenkontakt auf entgegengesetzten Seiten oder aber derselben physischen Seite (üblicherweise der Rückseite) der Solarzelle angeordnet sein. Zellentypen bei denen sich Frontseiten- und Rückseitenkontakt auf derselben physischen Seite befinden, sind insbesondere die IBC-Zellen (interdigited back contact-Zellen), bei denen Frontseiten- und Rückseitenkontakt auf der Rückseite der Zellen die Gebiete unterschiedlichen Leitungsträgertyps kontaktieren.

Die Teilzellen, die gleichzeitig mit der erfindungsgemäßen Kontaktvorrichtung getestet werden, können aus der Teilung ein und derselben Vollzelle oder aber verschiedener Vollzellen hervorgegangen sein.

Die flächigen Trägerelemente sind vorzugsweise als PCBs (printed circuit boards) ausgeführt. In diesem Zusammenhang bedeutet "flächig", dass die Trägerelemente in der Art einer Leiterplatte mit hervorgehobenen Kontakten und/oder Leiterbahnen ausgeführt sind. Bevorzugt sind ein oder mehrere flächige Trägerelemente auf einem Tragrahmen (chuck) für Solarzellen angeordnet, vorzugsweise aufgeschraubt. Diese lösbare Verbindung gestattet es vorteilhaft, die flächigen Trägerelemente nach Bedarf zu wechseln.

In einer ersten Ausführungsform ist ein flächiges Trägerelement mit mindestens zwei Rückseitenkontaktanordnungen vorgesehen. Die Rückseitenkontaktierungen befinden sich auf dem flächigen Trägerelement und korrespondieren zu den Rückseitenkontakten der Teilzellen.

Korrespondieren heißt im vorliegenden Zusammenhang, dass die Rückseitenkontakte der Teilzellen nach dem Aufbringen der Teilzellen auf das jeweilige flächige Trägerelement eine elektrisch leitfähige Verbindung (durch Kontakt) zu der Rückseitenkontaktanordnung des flächigen Trägerelements herstellen. Dazu weist die Rückseitenkontaktanordnung des flächigen Trägerelements entsprechende Kontaktpunkte und/oder Leiterbahnen auf.

In einer zweiten Ausführungsform sind mindestens zwei flächige Trägerelemente mit jeweils mindestens einer Rückseitenkontaktanordnung vorgesehen. Jede Rückseitenkontaktanordnung korrespondiert zu mindestens einem Rückseitenkontakt einer der Teilzellen und kontaktiert den mindestens einen Rückseitenkontakt der Teilzelle elektrisch.

Weiterhin sind in beiden Ausführungsformen vorzugsweise am Rand des flächigen Trägerelements elektrische Anschlussmöglichkeiten für die elektrischen Zuleitungen der mindestens einen Messvorrichtung vorgesehen.

Die Haltevorrichtung fixiert die Teilzelle bzw. die Teilzellen von der Beleuchtungsseite her auf den jeweiligen flächigen Trägervorrichtungen. Die Haltevorrichtungen können bspw. als Gitter ausgeführt sein, das sich in einer Halteposition fixieren lässt, in der es die Teilzellen gegen das flächige Trägerelement (z.B. das PCB) presst. Weitere Haltevorrichtungen weisen eine oder mehrere Bügel, ein oder mehrere Federelemente oder eine sonstige lösbare Klemmvorrichtung auf. Andere mögliche Lösungen sehen eine oder mehrere Ansaugvorrichtungen vor.

In einer bevorzugten Ausführungsform ist die Haltevorrichtung ein Gitter oder eine Anordnung paralleler dünner Drähte.

In Ausführungsformen ist die mindestens eine Frontseitenkontaktanordnung unabhängig von der mindestens einen Haltevorrichtung auf der Beleuchtungsseite der Teilzellen angeordnet. Optional kann die Frontseitenkontaktanordnung gemeinsam mit den Teilzellen durch die Haltevorrichtung in ihrer Position fixiert werden.

Optional ist die mindestens eine Frontseitenkontaktanordnung ebenfalls auf dem oder den Trägerelementen, jedoch elektrisch isoliert von den Rückseitenkontaktanordnungen ausgeführt. Diese Anordnungsvariante ist für IBC-Zellen bevorzugt.

Weiterhin optional fungiert die Haltevorrichtung, bevorzugt das Gitter, auch als Frontseitenkontaktanordnung zur Kontaktierung der Frontseitenkontakte der Teilzellen.

Zur Messung ist vorgesehen, dass entweder die Rückseitenkontakte aller Teilzellen auf der mindestens einen flächigen Trägervorrichtung auf ein gemeinsames Potential gelegt werden oder aber, dass alle Frontseitenkontakte der Teilzellen auf ein gemeinsames Potential gelegt werden.

Mit der erfindungsgemäßen Kontaktvorrichtung können weitere relevante Daten der Solarzellen ermittelt werden. Dies sind bspw.:
- lokale Temperaturerhöhungen gemessen mit einer Thermokamera (Bolometer) parallel zur Bestimmung der Rückwärtsströme
- Elektrolumineszenz - Bilder der Teilzellen.

Die zugehörigen Sensoren sind dann in die Kontaktvorrichtung, z.B. in die Haltevorrichtung oder das Trägerelement oder eine der Kontaktanordnungen, integriert.

Die erfindungsgemäße Anordnung zur Charakterisierung (Testung, Qualifizierung) von aus der Teilung von Vollzellen hervorgegangenen Teilzellen, weist eine Beleuchtungsvorrichtung zur Charakterisierung von Vollzellen und einen Chuck zur Aufnahme von Vollzellen, auf dem eine oder mehrere Kontaktvorrichtungen angeordnet sind sowie mindestens eine Messvorrichtung auf. Die eine oder mehreren Kontaktvorrichtungen sind geeignet, mehrere Teilzellen zu kontaktieren. Die eine oder mehreren Messvorrichtungen sind zur Erfassung von Messwerten während eines Belichtungsvorganges der mehreren Teilzellen mittels der Beleuchtungsvorrichtung eingerichtet.

Erfindungsgemäß sind die eine oder mehreren Messvorrichtungen dazu eingerichtet, eine zeitgleiche Messung zwischen
- den Rückseitenkontaktanordnungen der einzelnen Teilzellen und der gemeinsamen Frontkontaktanordnung, oder aber
- der Frontseitenkontaktanordnung der einzelnen Teilzellen und der gemeinsamen Rückkontaktanordnung
während eines Beleuchtungsvorganges
oder aufeinanderfolgende Messungen an jeder Teilzelle zwischen
- den Rückseitenkontaktanordnungen jeweils einer der Teilzellen und der gemeinsamen Frontkontaktanordnung, oder aber
- der Frontseitenkontaktanordnung jeweils einer der Teilzellen und der gemeinsamen Rückkontaktanordnung
während aufeinanderfolgender Beleuchtungsvorgänge, vorzunehmen.

Der prinzipielle Aufbau der erfindungsgemäßen Anordnung zur Charakterisierung entspricht dem aus dem Stand der Technik bekannten Aufbau von Anordnungen zur Charakterisierung von Vollzellen. Durch den Einsatz der erfindungsgemäßen Kontaktvorrichtung in einer Anlage zur Charakterisierung von Vollzellen werden umfangreiche Neuanschaffungen oder Umbauten obsolet.

Da die erfindungsgemäße Kontaktvorrichtung die Qualifizierung mehrerer Teilzellen ermöglicht, sind lediglich die Zahl oder der Aufbau der Messvorrichtungen so anzupassen, dass eine parallele (simultane) oder serielle Erfassung der I-U-Kennlinien der Teilzellen möglich ist.

Die parallele Erfassung wird erreicht, indem jeder zu qualifizierenden Teilzelle eine an sich bekannte Messvorrichtung zugeordnet wird.

Die erfindungsgemäße Anordnung kann vorteilhaft zur simultanen Charakterisierung mehrerer Teilzellen mittels einer Beleuchtungsvorrichtung für Vollzellen aus dem Stand der Technik verwendet werden.

Das erfindungsgemäße Verfahren zur Charakterisierung von aus Vollzellen durch Teilung hervorgegangener Teilzellen, weist in einer ersten Vorgehensweise mindestens die folgenden Schritte auf:
- Bereitstellen einer erfindungsgemäßen Anordnung zur Charakterisierung (Testung, Qualifizierung) von aus der Teilung von Vollzellen hervorgegangenen Teilzellen,
- Anordnen von mindestens zwei Teilzellen auf der Kontaktvorrichtung und Fixieren der Teilzellen mittels der mindestens einen Haltevorrichtung,
- Elektrisches Kontaktieren von einer oder mehreren Messvorrichtungen mit den Rückseitenkontaktanordnungen und den Frontseitenkontaktanordnungen, und
- Simultane Beleuchtung aller Teilzellen und parallel dazu simultane Aufzeichnung der Messwerte aller auf der Kontaktvorrichtung befindlichen Teilzellen.

Eine serielle Erfassung kann realisiert werden, indem eine an sich bekannte Messvorrichtung mit einer Verschaltung versehen wird, die die eine Messvorrichtung nacheinander mit den zu messenden Teilzellen, d.h. mit den ihnen zugeordneten Kontaktanordnungen der mindestens einen Kontaktvorrichtung, verbindet und im Zuge mehrerer Beleuchtungsvorgänge jeweils eine Teilzelle charakterisiert.

Das Verfahren zur Charakterisierung von aus der Teilung von Vollzellen hervorgegangenen Teilzellen weist in einer zweiten Vorgehensweise somit mindestens die folgenden Schritte auf:
a) Bereitstellen erfindungsgemäßen Anordnung zur Charakterisierung (Testung, Qualifizierung) von aus der Teilung von Vollzellen hervorgegangenen Teilzellen,
b) Anordnen von mindestens zwei Teilzellen auf der Kontaktvorrichtung und Fixieren der Teilzellen mittels der mindestens einen Haltevorrichtung,
c) Elektrisches Kontaktieren der Messvorrichtungen mit den Rückseitenkontaktanordnungen und den Frontseitenkontaktanordnungen einer ersten Teilzelle und
d) simultane Beleuchtung aller Teilzellen und parallel dazu Aufzeichnung der Messwerte der ersten Teilzelle,
e) Elektrisches Kontaktieren der Messvorrichtungen mit den Rückseitenkontaktanordnungen und den Frontseitenkontaktanordnungen einer weiteren Teilzelle und
f) simultane Beleuchtung aller Teilzellen und parallel dazu Aufzeichnung der Messwerte der weiteren Teilzelle,
g) Wiederholung der Schritte e) und f) bis alle Teilzellen vermessen sind.

Aus den erfassten Messwerten werden die elektrischen Kenndaten (I-U-Kennlinien) der einzelnen Teilzellen ermittelt. Dies erfolgt vorzugsweise, in einer oder mehreren Datenverarbeitungsvorrichtungen, die in den Messvorrichtungen enthalten sind bzw. an die die Daten der Messvorrichtungen übertragen werden.

Die Erfindung ist nicht auf die dargestellten und beschriebenen Ausführungsformen beschränkt, sondern umfasst auch alle im Sinne der Erfindung gleich wirkenden Ausführungsformen. Ferner ist die Erfindung auch nicht auf die speziell beschriebenen Merkmalskombinationen beschränkt, sondern kann auch durch jede beliebige andere Kombination von bestimmten Merkmalen aller insgesamt offenbarten Einzelmerkmale definiert sein, sofern sich die Einzelmerkmale nicht gegenseitig ausschließen, oder eine spezifische Kombination von Einzelmerkmalen nicht explizit ausgeschlossen ist.

### Figuren

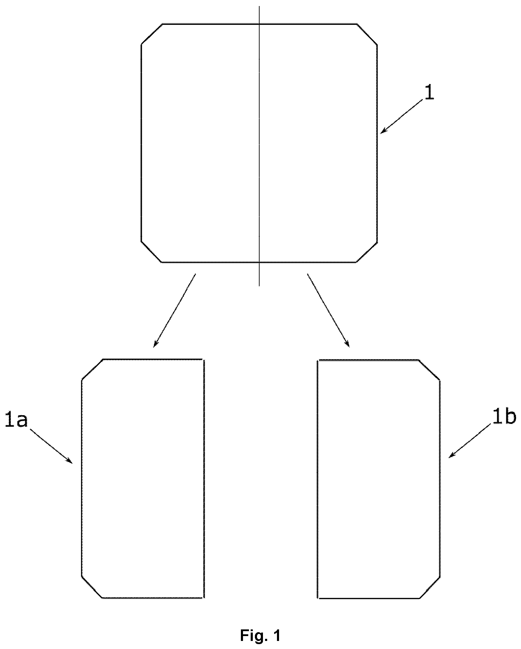

**Fig. 1** zeigt schematisch die Aufteilung einer Vollzelle 1 in eine erste Halbzelle 1a und eine zweite Halbzelle 1b.

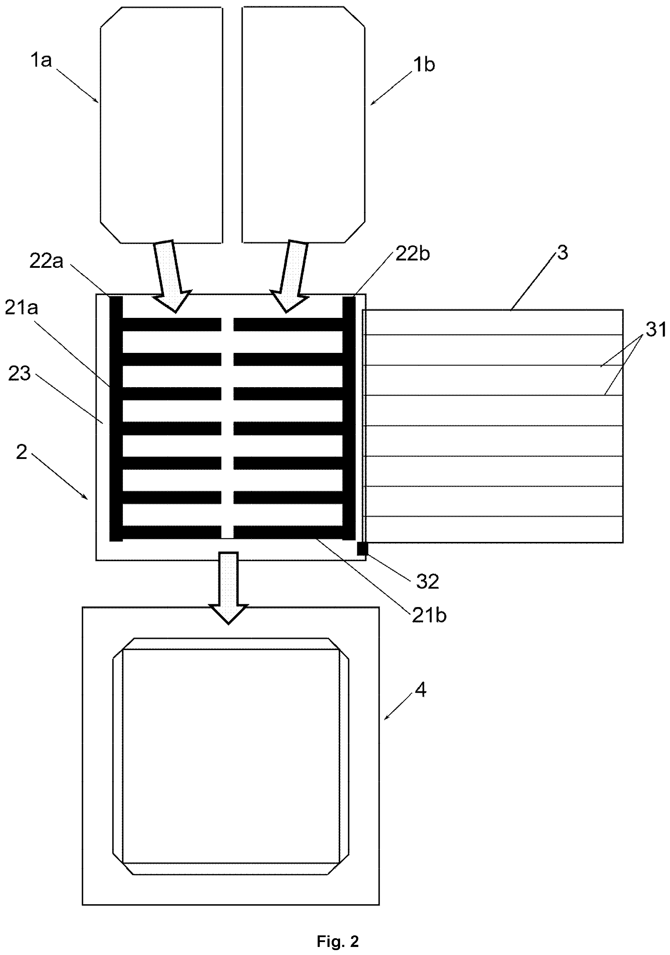

**Fig. 2** zeigt schematisch eine erste Ausführungsform einer Kontaktvorrichtung 2, auf der die erste und die zweite Halbzelle 1a, 1b angeordnet werden können. Die Kontaktvorrichtung 2 weist ein flächiges Trägerelement 23 auf, auf dem zwei elektrisch voneinander getrennte Rückseitenkontaktanordnungen 21a, 21b als Leiterbahnen aufgebracht sind. Die elektrisch voneinander getrennten Rückseitenkontaktanordnungen 21a, 21b werden an Anschlusspunkten 22a, 22b elektrisch kontaktiert. Weiterhin weist die Kontaktvorrichtung 2 eine Haltevorrichtung auf, die gleichzeitig als gemeinsame Frontseitenkontaktanordnung 3 fungiert und die in der gezeigten Ausführungsform auf dem Trägerelement 23 befestigt ist. Die Frontseitenkontaktanordnung 3 ist als Gitter 31 ausgeführt. Sie wird über einen Anschlusspunkt 32 elektrisch kontaktiert. Fig. 2 zeigt weiterhin, einen Tragrahmen 4 (Chuck), der die Kontaktvorrichtung 2 aufnimmt, auf der wiederum die beiden Halbzellen 1a, 1b angeordnet werden.

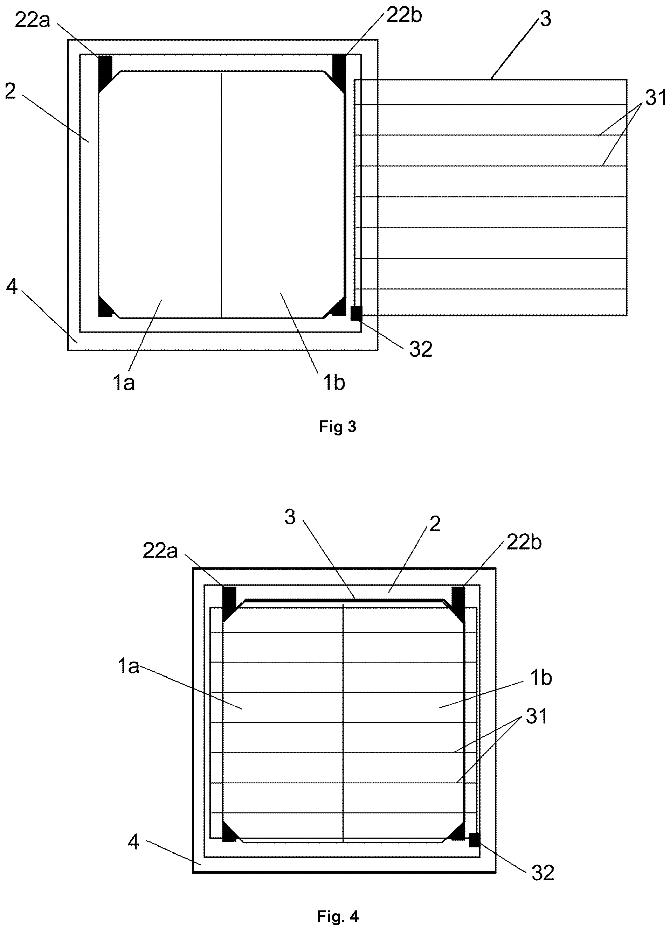

**Fig. 3** zeigt schematisch in einer Draufsicht, wie die beiden Halbzellen 1a, 1b auf der Kontaktvorrichtung 2 nach Fig 2 angeordnet sind. Die Haltevorrichtung/Frontseitenkontaktanordnung 3 ist noch nicht geschlossen.
**Fig. 4** zeigt schematisch die Draufsicht nach Fig. 3 mit geschlossener Haltevorrichtung (Gitter)/Frontseitenkontaktanordnung 3.

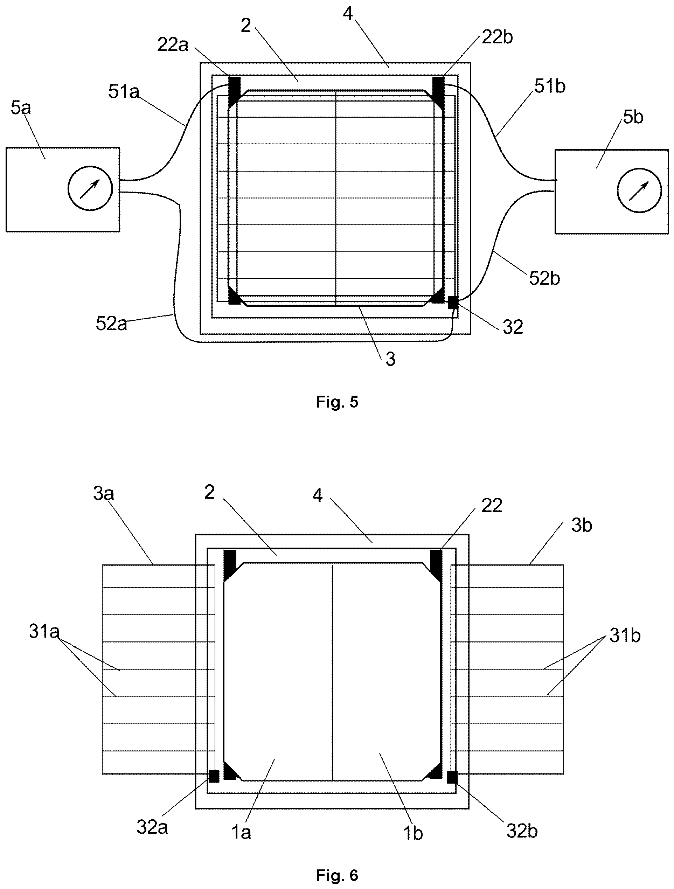

**Fig. 5** zeigt schematisch die Messanordnung für die erste Ausführungsform der Kontaktvorrichtung 2 mit getrennten Rückseitenkontaktanordnungen für jede Halbzelle 1a, 1b und einer gemeinsamen Frontseitenkontaktanordnung 3. Die erste Messvorrichtung 5a kontaktiert die erste Rückseitenkontaktanordnung (nicht dargestellt) am Anschlusspunkt 22a mittels der elektrischen Zuleitung 51a sowie den gemeinsamen Anschlusspunkt 32 der Frontseitenkontaktanordnung 3 mittels der elektrischen Zuleitung 52a. Die zweite Messvorrichtung 5b kontaktiert die zweite Rückseitenkontaktanordnung (nicht dargestellt) am Anschlusspunkt 22b mittels der elektrischen Zuleitung 51b sowie den gemeinsamen Anschlusspunkt 32 der Frontseitenkontaktanordnung 3 mittels der elektrischen Zuleitung 52b.
**Fig. 6** zeigt in einer Draufsicht schematisch eine zweite Ausführungsform einer Kontaktvorrichtung 2, auf der die erste und die zweite Halbzelle 1a, 1b angeordnet sind, wobei die Kontaktvorrichtung 2 hier eine gemeinsame Rückseitenkontaktanordnung (nicht dargestellt) und zwei elektrisch voneinander getrennte Frontseitenkontaktanordnungen 3a, 3b aufweist. Die gemeinsame Rückseitenkontaktanordnung wird über den Anschlusspunkt 22 elektrisch kontaktiert. Jede der beiden Frontseitenkontaktanordnungen 3a, 3b ist als Gitter 31a, 31b ausgeführt. Die beiden Gitter 31a, 31b fungieren weiterhin als Haltevorrichtung für die beiden Halbzellen 1a, 1b. Die Kontaktvorrichtung 2 ist ihrerseits auf dem Tragrahmen 4 angeordnet.

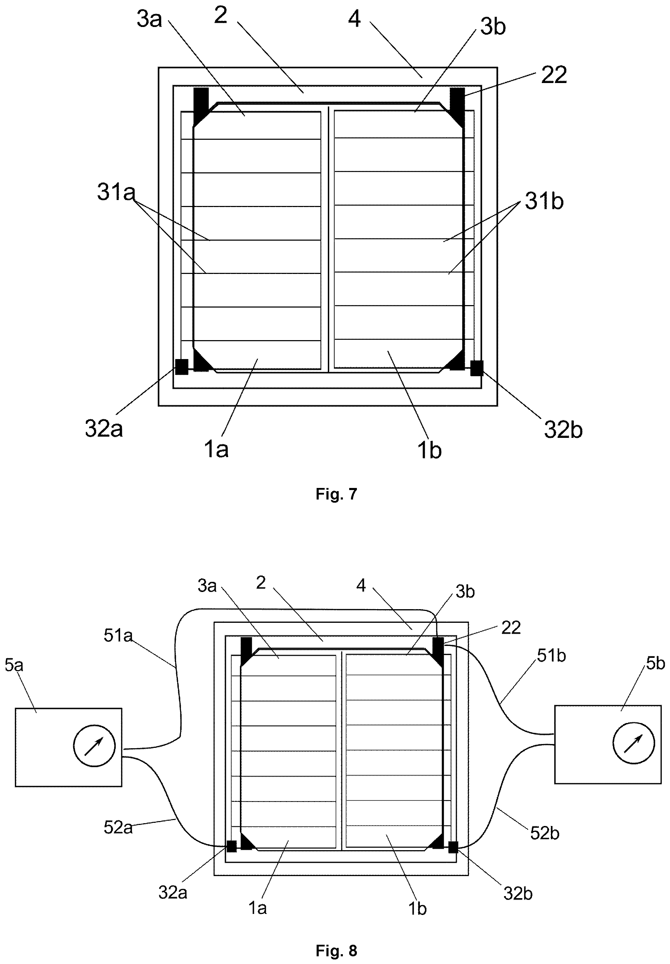

**Fig. 7** zeigt schematisch die Draufsicht nach Fig. 6 mit geschlossenen Haltevorrichtungen (Gittern)/Frontseitenkontaktanordnungen 3a,3b.
**Fig. 8** zeigt schematisch die Messanordnung für die zweite Ausführungsform der Kontaktvorrichtung 2 mit getrennten Gittern 31a, 31b als Frontseitenkontaktanordnungen 3a, 3b für jede Halbzelle 1a, 1b und einer gemeinsamen Rückseitenkontaktanordnung (nicht dargestellt). Die erste Messvorrichtung 5a kontaktiert die erste Frontseitenkontaktanordnung 3a am Anschlusspunkt 32a mittels der elektrischen Zuleitung 52a sowie den gemeinsamen Anschlusspunkt 22 der Rückseitenkontaktanordnung mittels der elektrischen Zuleitung 51a. Die zweite Messvorrichtung 5b kontaktiert die zweite Frontseitenkontaktanordnung 3b am Anschlusspunkt 32b mittels der elektrischen Zuleitung 52b sowie den gemeinsamen Anschlusspunkt 22 der Rückseitenkontaktanordnung mittels der elektrischen Zuleitung 51b.

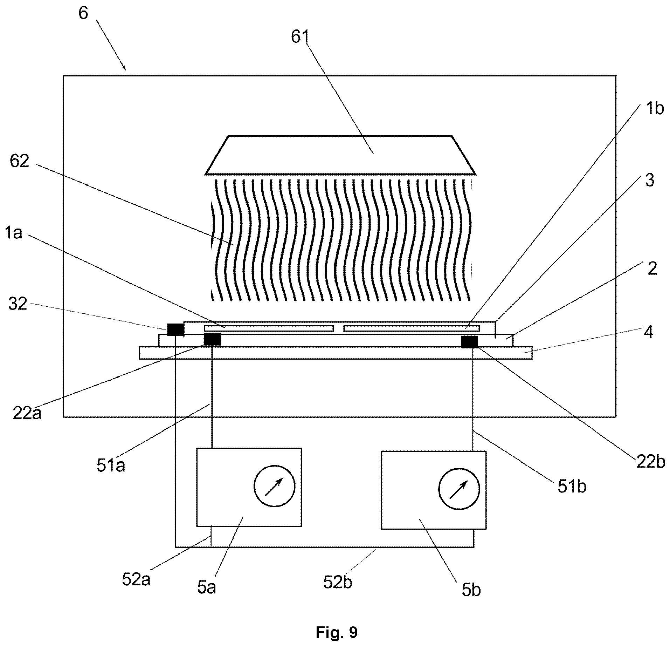

**Fig. 9** zeigt schematisch die Anordnung der Kontaktvorrichtung 2, getragen von dem Chuck 4, in einer herkömmlichen Vorrichtung 6 zur Qualifizierung von Vollzellen (Testvorrichtung). Die Kontaktvorrichtung 2 weist getrennte Rückseitenkontaktanordnungen sowie eine gemeinsame Frontseitenkontaktanordnung 3 auf (analog zur ersten Ausführungsform der Kontaktvorrichtung in Fig. 2). Schematisch werden die parallelen Messungen an den beiden Halbzellen 1a, 1b angedeutet. Die Messungen erfolgen, wenn eine Beleuchtungsvorrichtung 61, die z.B. Halogenlampen aufweist, einen Lichtblitz 62 gleichzeitig auf beide Halbzellen 1a, 1b aussendet.

### Ausführungsbeispiel

Eine beispielhafte erfindungsgemäße Kontaktvorrichtung 2 weist ein flächiges Trägerelement 23 auf, das als PCB ausgeführt ist. Die Abmessungen des PCB betragen 170 mm x 170 mm. Auf dem PCB sind zwei elektrisch voneinander getrennte Rückseitenkontaktanordnungen 21a, 21b aufgebracht, wobei die Kontakte jeweils einer Rückseitenkontaktanordnung 21a, 21b mit den Rückseitenkontakten von jeweils einer Halbzelle 1a, 1b korrespondieren. Jede Rückseitenkontaktanordnung 21a, 21b weist weiterhin Leiterbahnen auf, die zu Anschlusspunkten 22a, 22b für die Messvorrichtungen an der Seite des flächigen Trägerelements 23 führen. Die Halbzellen 1a, 1b können somit elektrisch getrennt voneinander an eine jeweils einzelne oder gemeinsame Messvorrichtung angeschlossen und getrennt voneinander mit einem Rückseitenpotential beaufschlagt werden. Das flächige Trägerelement 23 ist auf einen Chuck (Tragrahmen) 4 des Typs CELL CONTACTING UNIT der Fa. Pasan S.A. für Vollzellen aufgeschraubt.

Weiterhin trägt das flächige Trägerelement 23 ein klappbares Gitter 31, das neben dem Halten der Halbzellen 1a, 1b in ihrer Position auch die Frontseitenkontaktierung beider Halbzellen 1a, 1b realisiert. Das Gitter 31 besteht aus einem leitfähigen Material. Am Anlenkpunkt des Gitters 31 auf dem flächigen Trägerelement 23 ist ein Anschlusspunkt 32 für die Messvorrichtungen vorgesehen. An diesem Anschlusspunkt wird das gemeinsame Frontseitenpotential für alle auf dem flächigen Trägerelement 23 angeordneten Teilzellen angelegt.

Zur Messung werden auf die Kontaktvorrichtung 2 zwei Halbzellen 1a, 1b aufgelegt, die aus der mittigen Teilung von Vollzellen hervorgegangen sind. Die Halbzellen 1a, 1b werden durch das Gitter 31 auf dem flächigen Trägerelement fixiert. Dabei werden die Frontseitenkontakte durch das Gitter 31 gemeinsam und die Rückseitenkontakte der beiden Halbzellen 1a, 1b durch die Rückseitenkontaktanordnungen 21a, 21b getrennt kontaktiert. Das Gitter 31 arbeitet somit auch als Frontseitenkontaktanordnung 3. Es werden zwei Messvorrichtungen 5a, 5b, die zur Testvorrichtung vom Typ SpotLIGHT XLP/XLS150 gehören, über den Anschlusspunkt 32 der Frontseitenkontaktanordnung 3 mit den Halbzellen 1a, 1b elektrisch verbunden.

Der Chuck 4 mit der Kontaktvorrichtung 2 und den Halbzellen 1a, 1b wird in die herkömmliche Testvorrichtung 6 vom Typ SpotLIGHT XLP/XLS150 eingebracht. Nunmehr erfolgt eine Erfassung der elektrischen Kenndaten der Halbzellen 1a, 1b während der Beleuchtungsvorgänge (Lichtblitze 62). Die Lichtblitze 62 werden mittels einer kombinierten Xenon-LED-Lampen-Beleuchtung der Beleuchtungsvorrichtung 61 für eine Zeitdauer von 5 ms Xenon-Licht und bis zu 600ms LED-Licht erzeugt. Im Rahmen der Erfassung der elektrischen Kennwerte werden Strom-Spannungs-Kennlinien erzeugt.

Die Strom-/Spannungskennlinien werden über bis zu 3 Quadranten als Strom-Spannungsmesspaare aufgezeichnet (Hellkennlinie -> beleuchtet in Flussrichtung der Diode, Dunkelkennlinie -> unbeleuchtet in Flussrichtung, inverse Dunkelkennlinie -> unbeleuchtet in Sperrrichtung)

Aus den Messwerten werden die elektrischen Kenndaten der beiden Halbzellen 1a, 1b ermittelt. Dazu gehören:

| **Wert** | **Kurzbezeichner** | **Beschreibung** |
|---|---|---|
| Kurzschlussstrom | Isc | Maximaler Strom unter Beleuchtung |
| Leerlaufspannung | Uoc | Maximale Spannung unter Beleuchtung |
| Füllfaktor | FF | Verhältnis der maximalen Leistung der Zelle zur theoretisch erreichbaren maximalen Leistung der Zelle: Pmpp/(Isc*Voc) |
| Maximale Leistung der Zelle | Pmpp | Maximale Leistung der Zelle: V*I (V) |
| Spannung bei der maximalen Zellleistung | Umpp | |
| Strom bei der maximalen Zelleistung | Impp | |
| Wirkungsgrad der Zelle | ETA | Leistung der Zelle im Bezug zur eingestrahlten Lichtleistung |
| Serienwiderstand | Rser | Berechneter innerer Serienwiderstand der Solarzelle aus dem vereinfachten Solarzellen- Ersatzschaltbild |
| Parallelwiderstand (Shunt Widerstand) | Rsh | Berechneter innerer Parallelwiderstand der Solarzelle aus dem vereinfachten Solarzellen- Ersatzschaltbild |
| Rückwärtsstrom der Solarzelle bei inversem Betrieb | Irev | Rückwärtsstrom bei unterschiedlichen Rückwärtsspannungen, die aktiv an der Zelle angelegt werden. |

Anhand der ermittelten elektrischen Kennwerte können die Halbzellen 1a, 1b anschließend in unterschiedliche Qualitätsstufen eingeordnet werden. Insbesondere können Teilzellen mit ähnlichen Charakteristiken in gemeinsamen Solarmodulen zusammengefasst werden.

### Bezugszeichenliste

- 1: Vollzelle
- 1a: erste Halbzelle
- 1b: zweite Halbzelle
- 2: Kontaktvorrichtung
- 21a: erste Rückseitenkontaktanordnung
- 21b: zweite Rückseitenkontaktanordnung
- 22: Anschlusspunkt einer Rückseitenkontaktanordnung
- 22a: Anschlusspunkt der ersten Rückseitenkontaktanordnung
- 22b: Anschlusspunkt der zweiten Rückseitenkontaktanordnung
- 23: flächiges Trägerelement (PCB)
- 3: Frontseitenkontaktanordnung
- 31: Gitter der Frontseitenkontaktanordnung
- 31a: erstes Gitter der Frontseitenkontaktanordnung
- 31b: zweites Gitter der Frontseitenkontaktanordnung
- 32: Anschlusspunkt der Frontseitenkontaktanordnung
- 32a: Anschlusspunkt der ersten Frontseitenkontaktanordnung
- 32b: Anschlusspunkt der zweiten Frontseitenkontaktanordnung
- 4: Tragrahmen (Chuck)
- 5a: erste Messvorrichtung
- 5b: zweite Messvorrichtung
- 51a: erste elektrische Zuleitung von einem Rückseitenkontakt zur ersten Messvorrichtung
- 51b: erste elektrische Zuleitung von einem Rückseitenkontakt zur zweiten Messvorrichtung
- 52a: zweite elektrische Zuleitung von einem Frontseitenkontakt zur ersten Messvorrichtung
- 52b: zweite elektrische Zuleitung von einem Frontseitenkontakt zur zweiten Messvorrichtung
- 6: herkömmliche Testvorrichtung für Vollzellen
- 61: Beleuchtungsvorrichtung
- 62: Lichtblitz

## Patentansprüche

1. Kontaktvorrichtung zur Kontaktierung mehrerer aus Vollzellen durch Teilung hervorgegangener und physisch und elektrisch voneinander getrennter Teilzellen, wobei jede der Teilzellen mindestens einen Rückseitenkontakt und mindestens einen Frontseitenkontakt aufweist,
wobei die Kontaktvorrichtung umfasst:
- ein flächiges Trägerelement mit mindestens zwei Rückseitenkontaktanordnungen oder mindestens zwei flächige Trägerelemente mit jeweils mindestens einer Rückseitenkontaktanordnung, wobei jede Rückseitenkontaktanordnung zu dem mindestens einen Rückseitenkontakt einer der Teilzellen korrespondiert und geeignet ist, den mindestens einen Rückseitenkontakt der Teilzelle elektrisch zu kontaktieren,
- mindestens eine Frontseitenkontaktanordnung, wobei jede Frontseitenkontaktanordnung zu dem mindestens einen Frontseitenkontakt einer der Teilzellen korrespondiert und geeignet ist, den mindestens einen Frontseitenkontakt der Teilzelle elektrisch zu kontaktieren, und
- mindestens eine Haltevorrichtung zur Fixierung der Teilzellen auf dem oder den flächigen Trägerelementen,
**dadurch gekennzeichnet, dass**
a) die Rückseitenkontaktanordnungen der einzelnen Teilzellen getrennt elektrisch kontaktierbar sind, während die Frontseitenkontaktanordnungen aller Teilzellen elektrisch zu einer gemeinsamen Frontkontaktanordnung verbunden und mit einem gemeinsamen Frontseitenpotential kontaktierbar sind,
oder
b) die Frontseitenkontaktanordnungen der einzelnen Teilzellen getrennt elektrisch kontaktierbar sind, während die Rückseitenkontaktanordnungen aller Teilzellen elektrisch zu einer gemeinsamen Rückkontaktanordnung verbunden und mit einem gemeinsamen Rückseitenpotential kontaktierbar sind.

2. Kontaktvorrichtung nach Anspruch 1, **dadurch gekennzeichnet, dass** die mindestens eine Frontseitenkontaktanordnung ebenfalls auf dem oder den Trägerelementen, jedoch elektrisch isoliert von den Rückseitenkontaktanordnungen ausgeführt ist.

3. Kontaktvorrichtung nach Anspruch 1, **dadurch gekennzeichnet, dass** die mindestens eine Frontseitenkontaktanordnung unabhängig von der mindestens einen Haltevorrichtung auf einer Beleuchtungsseite der Teilzellen angeordnet ist.

4. Kontaktvorrichtung nach Anspruch 1, **dadurch gekennzeichnet, dass** die mindestens eine Frontseitenkontaktanordnung in die Haltevorrichtung integriert ist.

5. Kontaktvorrichtung nach einem der vorhergehenden Ansprüche, **dadurch gekennzeichnet, dass** die mindestens eine Haltevorrichtung ein Gitter, eine oder mehrere Bügel, ein oder mehrere Federelemente oder eine sonstige lösbare Klemmvorrichtung umfasst.

6. Kontaktvorrichtung nach einem der Ansprüche 1 bis 3 oder 5, **dadurch gekennzeichnet, dass** die mindestens eine Haltevorrichtung eine Ansaugvorrichtung umfasst.

7. Kontaktvorrichtung nach einem der vorhergehenden Ansprüche **dadurch gekennzeichnet, dass** das oder die Trägerelemente als Printed Circuit Board (PCB) ausgeführt sind.

8. Anordnung zur Charakterisierung von aus der Teilung von Vollzellen hervorgegangenen Teilzellen, aufweisend eine Beleuchtungsvorrichtung zur Charakterisierung von Solarzellen, einen Chuck zur Aufnahme von Solarzellen, auf dem eine Kontaktvorrichtung nach einem der Ansprüche 1 bis 7 angeordnet ist, die geeignet ist, mehrere Teilzellen zu kontaktieren, sowie eine oder mehrere Messvorrichtungen die zur Erfassung von Messwerten während eines Belichtungsvorganges der mehreren Teilzellen mittels der Beleuchtungsvorrichtung geeignet sind, **dadurch gekennzeichnet, dass**
jeder Teilzelle eine Messvorrichtung zugeordnet ist und die mehreren Messvorrichtungen dazu eingerichtet sind, eine zeitgleiche Messung zwischen
- den Rückseitenkontaktanordnungen der einzelnen Teilzellen und der gemeinsamen Frontkontaktanordnung, oder aber
- der Frontseitenkontaktanordnung der einzelnen Teilzellen und der gemeinsamen Rückkontaktanordnung
während des Beleuchtungsvorganges vorzunehmen,
oder die eine Messvorrichtung aufeinanderfolgende Messungen an jeder Teilzelle zwischen
- den Rückseitenkontaktanordnungen jeweils einer der Teilzellen und der gemeinsamen Frontkontaktanordnung, oder aber
- der Frontseitenkontaktanordnung jeweils einer der Teilzellen und der gemeinsamen Rückkontaktanordnung
während aufeinanderfolgender Beleuchtungsvorgänge, vornimmt, wobei eine Verschaltung die eine Messvorrichtung nach jedem Beleuchtungsvorgang mit einer anderen Teilzelle verbindet, bis alle Teilzellen charakterisiert sind.

9. Verfahren zur Charakterisierung von aus der Teilung von Vollzellen hervorgegangenen Teilzellen, aufweisend mindestens die folgenden Schritte:
- Bereitstellen einer Anordnung nach Anspruch 8,
- Anordnen von mindestens zwei Teilzellen auf der Kontaktvorrichtung und Fixieren der Teilzellen mittels der mindestens einen Haltevorrichtung,
- Elektrisches Kontaktieren der Messvorrichtungen mit den Rückseitenkontaktanordnungen und den Frontseitenkontaktanordnungen und
- Simultane Beleuchtung aller Teilzellen und parallel dazu simultane Aufzeichnung der Messwerte aller auf der Kontaktvorrichtung befindlichen Teilzellen.

10. Verfahren zur Charakterisierung von aus der Teilung von Vollzellen hervorgegangenen Teilzellen, aufweisend mindestens die folgenden Schritte:
a) Bereitstellen einer Anordnung nach Anspruch 8,
b) Anordnen von mindestens zwei Teilzellen auf der Kontaktvorrichtung und Fixieren der Teilzellen mittels der mindestens einen Haltevorrichtung,
c) Elektrisches Kontaktieren der Messvorrichtungen mit den Rückseitenkontaktanordnungen und den Frontseitenkontaktanordnungen einer ersten Teilzelle und
d) simultane Beleuchtung aller Teilzellen und parallel dazu Aufzeichnung der Messwerte der ersten Teilzelle,
e) Elektrisches Kontaktieren der Messvorrichtungen mit den Rückseitenkontaktanordnungen und den Frontseitenkontaktanordnungen einer weiteren Teilzelle und
f) simultane Beleuchtung aller Teilzellen und parallel dazu Aufzeichnung der Messwerte der weiteren Teilzelle,
g) Wiederholung der Schritte e) und f) bis alle Teilzellen vermessen sind.

11. Verfahren nach Anspruch 9 oder 10, **dadurch gekennzeichnet, dass** aus den Messwerten die elektrischen Kenndaten (I-U-Kennlinien) der einzelnen Teilzellen ermittelt werden.

12. Verwendung einer Anordnung nach Anspruch 8 zur simultanen oder seriellen Charakterisierung mehrerer Teilzellen mittels einer Beleuchtungsvorrichtung für Vollzellen.

## Geänderte Patentansprüche

### Geänderte Patentansprüche gemäss Regel 137(2) EPÜ.

1. Kontaktvorrichtung zur Kontaktierung mehrerer aus Vollzellen (1) durch Teilung hervorgegangener und physisch und elektrisch voneinander getrennter Teilzellen (1a, 1b), wobei jede der Teilzellen (1a, 1b) mindestens einen Rückseitenkontakt und mindestens einen Frontseitenkontakt aufweist,
wobei die Kontaktvorrichtung umfasst:
- ein flächiges Trägerelement (23) mit mindestens zwei Rückseitenkontaktanordnungen (21a, 21b) oder mindestens zwei flächige Trägerelemente (23) mit jeweils mindestens einer Rückseitenkontaktanordnung (21a, 21b), wobei jede Rückseitenkontaktanordnung (21a, 21b) zu dem mindestens einen Rückseitenkontakt einer der Teilzellen (1a, 1b) korrespondiert und geeignet ist, den mindestens einen Rückseitenkontakt der Teilzelle (1a, 1b) elektrisch zu kontaktieren,
- mindestens eine Frontseitenkontaktanordnung (3), wobei jede Frontseitenkontaktanordnung (3) zu dem mindestens einen Frontseitenkontakt einer der Teilzellen (1a, 1b) korrespondiert und geeignet ist, den mindestens einen Frontseitenkontakt der Teilzelle (1a, 1b) elektrisch zu kontaktieren, und
- mindestens eine Haltevorrichtung zur Fixierung der Teilzellen (1a, 1b) auf dem oder den flächigen Trägerelementen (23),
**dadurch gekennzeichnet, dass**
a) die Rückseitenkontaktanordnungen (21a, 21b) der einzelnen Teilzellen (1a, 1b) getrennt elektrisch kontaktierbar sind, während die Frontseitenkontaktanordnungen (3) aller Teilzellen (1a, 1b) elektrisch zu einer gemeinsamen Frontkontaktanordnung (3) verbunden und mit einem gemeinsamen Frontseitenpotential kontaktierbar sind,
oder
b) die Frontseitenkontaktanordnungen (3) der einzelnen Teilzellen (1a, 1b) getrennt elektrisch kontaktierbar sind, während die Rückseitenkontaktanordnungen (21a, 21b) aller Teilzellen elektrisch zu einer gemeinsamen Rückkontaktanordnung verbunden und mit einem gemeinsamen Rückseitenpotential kontaktierbar sind.

2. Kontaktvorrichtung nach Anspruch 1, **dadurch gekennzeichnet, dass** die mindestens eine Frontseitenkontaktanordnung (3) ebenfalls auf dem oder den Trägerelementen /23), jedoch elektrisch isoliert von den Rückseitenkontaktanordnungen (21a, 21b) ausgeführt ist.

3. Kontaktvorrichtung nach Anspruch 1, **dadurch gekennzeichnet, dass** die mindestens eine Frontseitenkontaktanordnung (3) unabhängig von der mindestens einen Haltevorrichtung auf einer Beleuchtungsseite der Teilzellen (1a, 1b) angeordnet ist.

4. Kontaktvorrichtung nach Anspruch 1, **dadurch gekennzeichnet, dass** die mindestens eine Frontseitenkontaktanordnung (3) in die Haltevorrichtung integriert ist.

5. Kontaktvorrichtung nach einem der vorhergehenden Ansprüche, **dadurch gekennzeichnet, dass** die mindestens eine Haltevorrichtung ein Gitter (31), eine oder mehrere Bügel, ein oder mehrere Federelemente oder eine sonstige lösbare Klemmvorrichtung umfasst.

6. Kontaktvorrichtung nach einem der Ansprüche 1 bis 3 oder 5, **dadurch gekennzeichnet, dass** die mindestens eine Haltevorrichtung eine Ansaugvorrichtung umfasst.

7. Kontaktvorrichtung nach einem der vorhergehenden Ansprüche **dadurch gekennzeichnet, dass** das oder die Trägerelemente (23) als Printed Circuit Board (PCB) ausgeführt sind.

8. Anordnung zur Charakterisierung von aus der Teilung von Vollzellen (1) hervorgegangenen Teilzellen (1a, 1b), aufweisend eine Beleuchtungsvorrichtung (61) zur Charakterisierung von Solarzellen, einen Chuck zur Aufnahme von Solarzellen, auf dem eine Kontaktvorrichtung (2) nach einem der Ansprüche 1 bis 7 angeordnet ist, die geeignet ist, mehrere Teilzellen (1a, 1b) zu kontaktieren, sowie eine oder mehrere Messvorrichtungen (5a, 5b) die zur Erfassung von Messwerten während eines Belichtungsvorganges der mehreren Teilzellen (1a, 1b) mittels der Beleuchtungsvorrichtung (61) geeignet sind, **dadurch gekennzeichnet, dass** jeder Teilzelle (1a, 1b) eine Messvorrichtung (5a, 5b) zugeordnet ist und die mehreren Messvorrichtungen (5a, 5b) dazu eingerichtet sind, eine zeitgleiche Messung zwischen
- den Rückseitenkontaktanordnungen (21a, 21b) der einzelnen Teilzellen (1a, 1b) und der gemeinsamen Frontkontaktanordnung (3), oder aber
- der Frontseitenkontaktanordnung (3) der einzelnen Teilzellen (1a, 1b) und der gemeinsamen Rückkontaktanordnung (21a, 21b)
während des Beleuchtungsvorganges vorzunehmen,
oder die eine Messvorrichtung (5a, 5b) aufeinanderfolgende Messungen an jeder Teilzelle (1a, 1b) zwischen
- den Rückseitenkontaktanordnungen (21a, 21b) jeweils einer der Teilzellen (1a, 1b) und der gemeinsamen Frontkontaktanordnung (3), oder aber
- der Frontseitenkontaktanordnung (3) jeweils einer der Teilzellen (1a, 1b) und der gemeinsamen Rückkontaktanordnung (21a, 21b)
während aufeinanderfolgender Beleuchtungsvorgänge, vornimmt, wobei eine Verschaltung die eine Messvorrichtung (5a, 6b) nach jedem Beleuchtungsvorgang mit einer anderen Teilzelle (1a, 1b) verbindet, bis alle Teilzellen(1a, 1b) charakterisiert sind.

9. Verfahren zur Charakterisierung von aus der Teilung von Vollzellen (1) hervorgegangenen Teilzellen (1a, 1b), aufweisend mindestens die folgenden Schritte:
- Bereitstellen einer Anordnung nach Anspruch 8,
- Anordnen von mindestens zwei Teilzellen (1a, 1b) auf der Kontaktvorrichtung(2) und Fixieren der Teilzellen (1a, 1b) mittels der mindestens einen Haltevorrichtung,
- Elektrisches Kontaktieren der Messvorrichtungen (5a, 5b) mit den Rückseitenkontaktanordnungen (21a, 21b) und den Frontseitenkontaktanordnungen (3) und
- Simultane Beleuchtung aller Teilzellen (1a, 1b) und parallel dazu simultane Aufzeichnung der Messwerte aller auf der Kontaktvorrichtung (2) befindlichen Teilzellen (1a, 1b).

10. Verfahren zur Charakterisierung von aus der Teilung von Vollzellen (1) hervorgegangenen Teilzellen (1a, 1b), aufweisend mindestens die folgenden Schritte:
a) Bereitstellen einer Anordnung nach Anspruch 8,
b) Anordnen von mindestens zwei Teilzellen (1a, 1b) auf der Kontaktvorrichtung (2) und Fixieren der Teilzellen (1a, 1b) mittels der mindestens einen Haltevorrichtung,
c) Elektrisches Kontaktieren der Messvorrichtungen (5a, 5b) mit den Rückseitenkontaktanordnungen (21a, 21b) und den Frontseitenkontaktanordnungen (3) einer ersten Teilzelle (1a) und
d) simultane Beleuchtung aller Teilzellen (1a, 1b) und parallel dazu Aufzeichnung der Messwerte der ersten Teilzelle (1a),
e) Elektrisches Kontaktieren der Messvorrichtungen (5a, 5b) mit den Rückseitenkontaktanordnungen (21a, 21b) und den Frontseitenkontaktanordnungen (3) einer weiteren Teilzelle (1b) und
f) simultane Beleuchtung aller Teilzellen (1a, 1b) und parallel dazu Aufzeichnung der Messwerte der weiteren Teilzelle (1b),
g) Wiederholung der Schritte e) und f) bis alle Teilzellen (1a, 1b) vermessen sind.

11. Verfahren nach Anspruch 9 oder 10, **dadurch gekennzeichnet, dass** aus den Messwerten die elektrischen Kenndaten (I-U-Kennlinien) der einzelnen Teilzellen (1a, 1b) ermittelt werden.

12. Verwendung einer Anordnung nach Anspruch 8 zur simultanen oder seriellen Charakterisierung mehrerer Teilzellen (1a, 1b) mittels einer Beleuchtungsvorrichtung (61) für Vollzellen (1).
